(19)

Europäisches
Patentamt
European
Patent Office
Office européen
des brevets

(11)  **EP 2 685 286 A1**

(12)  # EUROPEAN PATENT APPLICATION
published in accordance with Art. 153(4) EPC

(43)  Date of publication:
**15.01.2014  Bulletin 2014/03**

(51)  Int Cl.:
***G01T 3/06*** *(2006.01)*

(21)  Application number: **12754361.9**

(22)  Date of filing: **08.03.2012**

(86)  International application number:
**PCT/JP2012/056009**

(87)  International publication number:
**WO 2012/121346 (13.09.2012 Gazette 2012/37)**

(84)  Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30)  Priority:  **08.03.2011   JP 2011050731**

(71)  Applicants:
• **Tokuyama Corporation**
  **Shunan-shi, Yamaguchi 745-8648 (JP)**
• **Tohoku University**
  **Sendai-shi, Miyagi 980-8577 (JP)**

(72)  Inventors:
• **KAWAGUCHI, Noriaki**
  **Shunan-shi**
  **Yamaguchi 745-8648 (JP)**
• **FUKUDA, Kentaro**
  **Shunan-shi**
  **Yamaguchi 745-8648 (JP)**

• **SUYAMA, Toshihisa**
  **Shunan-shi**
  **Yamaguchi 745-8648 (JP)**
• **YOSHIKAWA, Akira**
  **Sendai-shi**
  **Miyagi 980-8577 (JP)**
• **YANAGIDA, Takayuki**
  **Sendai-shi**
  **Miyagi 980-8577 (JP)**
• **YOKOTA, Yui**
  **Sendai-shi**
  **Miyagi 980-8577 (JP)**
• **FUJIMOTO, Yutaka**
  **Sendai-shi**
  **Miyagi 980-8577 (JP)**

(74)  Representative: **Jackson, Martin Peter**
  **J A Kemp**
  **14 South Square**
  **Gray's Inn**
  **London WC1R 5JJ (GB)**

(54)  **NEUTRON BEAM DETECTION DEVICE**

(57)    The present invention is a neutron detection device comprising a neutron detection scintillator composed of a colquiriite-type fluoride single crystal, and a silicon photodiode, characterized in that the single crystal contains only Eu as a lanthanoid and contains 0.80 atom/nm$^3$ or more of $^6$Li, the content of Eu is 0.0025 to 0.05 mol%, and the thickness of the scintillator exceeds 1 mm. The present invention provides a neutron detection device which has a sufficiently high neutron detection efficiency, is equipped with a neutron detection unit minimally affected by gamma rays, and is compact as a whole and lightweight.

Fig. 3

**Description**

Technical Field:

This invention relates to a neutron detection device for use in the detection of a neutron. More specifically, the invention relates to a neutron detection device equipped with a thick neutron detection scintillator composed of a colquiriite-type fluoride single crystal, and a silicon photodiode, the crystal containing 0.80 atom/nm$^3$ or more of $^6$Li and having only a certain Eu content.

Background Art:

A neutron detection device is used in a radiation controlled area, such as a nuclear reactor, and in the security field. Detectors using a $^3$He gas, which utilize $^3$He(n,p)T reaction between $^3$He and neutrons, have been mainly used. neutrons are classified, according to energy, into a thermal neutron (about 0.025 eV), an epithermal neutron (about 1 eV), a slow neutron (0.03 to 100 eV), an intermediate neutron (0.1 to 500 keV), and a fast neutron (500 keV or more). A high energy neutron, for example, a fast neutron, is so low in the probability of occurrence of $^3$He(n,p)T reaction that a neutron detection device using a $^3$He gas exhibits a low sensitivity in detecting it. Thus, a main target to be detected by the neutron detection device is a thermal neutron which has low energy. In detecting a fast neutron, it is common practice to slow the fast neutron down to a thermal neutron with the use of a moderator formed of polyethylene or the like, and then perform detection. For example, use is made of a rem-counter or a Bonner sphere spectrometer in which a neutron detector unit using $^3$He is covered with a spherical polyethylene moderator.

As noted above, neutron detection devices using a $^3$He gas have long been used as neutron detection devices with high sensitivity to a thermal neutron. Because of the rarity of a $^3$He gas, however, the price of such devices has skyrocketed in recent years. Moreover, gas-type detectors are large-sized, and inconvenient to handle. Hence, switching to alternative technologies is desired. As an example of the alternative technology, a detection device having a $^6$LiF film formed on a light receiving surface of a silicon photodiode has been reported (Non-Patent Document 1). This detection device utilizes lithium-6 ($^6$Li) which, like $^3$He, causes a nuclear reaction with thermal neutrons. In the detection device, a thermal neutron is detected in the following manner: The nuclear reaction between a thermal neutron and $^6$Li generates an alpha ray, and the alpha ray is thrown onto the light receiving surface of the silicon photodiode. During this process, the current-voltage characteristics of the siliconphotodiodechange, and the thermal neutron can be detected based on this change. Such a detection device, however, has not yet been put to practical use. This is because the $^6$LiF film needs to be thickened in order to obtain sufficient detection efficiency for a neutron, but the $^6$LiF film has the property of absorbing an alpha ray, and so cannot be thickened. If the $^6$LiF film is thickened, many of the alpha rays generated by the nuclear reaction are absorbed during passage through the film, with the result that the amount of the alpha rays arriving at the silicon diode decreases.

A method using a neutron detection scintillator containing $^6$Li instead of the $^6$LiF film is conceivable as a solution to the problem of the thickness. The neutron detection scintillator, as used herein, refers to a scintillator composed of a substance which, when hit by a neutron, emits fluorescence. The $^6$Li-containing neutron detection scintillator emits light by the following mechanism: When the scintillator is irradiated with thermal neutrons, the thermal neutrons and $^6$Li cause a nuclear reaction to produce alpha rays, and the alpha rays excite luminescence center elements, to emit fluorescence. The $^6$Li-containing neutron detection scintillator can be thickened. This scintillator, like the $^6$LiF film, also has the property of absorbing alpha rays. With the scintillator, however, alpha rays are promptly converted into light emissions, and the emitted light is minimally absorbed within the scintillator. As far as the scintillator is transparent enough to allow the resulting fluorescence to arrive at the silicon photodiode, the emitted light is supposed to reach the light receiving surface, even if the thickness in a direction perpendicular to the light receiving surface is great.

However, even a detection device comprising a combination of the above-described $^6$Li-containing neutron detection scintillator and a silicon photodiode has not found practical use. Generally, the silicon photodiode has high sensitivity to light with a long wavelength, especially, light of about 900 nm, but has low sensitivity to light with a short wavelength of 400 nm or less. So far, $^6$Li glass scintillators have been generally used as $^6$Li-containing neutron detection scintillators. The emission wavelength of these scintillators is 395 nm, and the emission intensity at this wavelength is low. Thus, the conventional $^6$Li glass scintillators have been unsuitable for combination with the silicon photodiode.

An example of a neutron detection scintillator having a relatively long emission wavelength is terbium-doped gadolinium oxysulfide (Tb:Gd$_2$O$_2$S) with an emission wavelength of 540 nm. A neutron imaging machine having this scintillator in combination with an image intensifier has been proposed (Non-Patent Document 2). However, the effective atomic number of Tb:Gd$_2$O$_2$S is 61, and is very high compared with lithium calcium aluminum fluoride {(LiCaAlF$_6$) effective atomic number 14}, lithium strontium aluminum fluoride {(LiSrAlF$_6$) effective atomic number 30} or the like. Thus, Tb:Gd$_2$O$_2$S is sensitive to gamma rays, as well as to a neutron, so that a neutron detection device having a scintillator made of Tb:Gd$_2$O$_2$S has posed difficulty in detecting only a neutron. As a neutron detection scintillator having a relatively long emission wavelength, like Tb:$Gd_2O_2S$, europium-doped lithium iodide (Eu:$^6$LiI) is also named. Eu:$^6$LiI can also be combined with a silicon photodiode, but is difficult to process because of its severe deliquescent properties. Moreover, it has a relatively high effective atomic number of 46, and it is sensitive to gamma rays as well. Thus, it has been difficult for Eu:$^6$LiI to detect only a neutron.

The present inventors have previously proposed some neutron detection scintillators which can be used in combination with silicon photodiodes and which have so low effective atomic numbers as to hardly cause light emission in response to gamma rays.

Concretely, they have proposed in Patent Document 1 a neutron detection scintillator composed of a colquiriite-type fluoride monocrystal containing a period 4 element such as Ti, containing 0.80 atom/$nm^3$ or more of $^6$Li, and further containing Ce or/and Eu. The scintillator of Patent Document 1 emits light of a long wavelength because it contains the period 4 element. Thus, it can be combined with a silicon photodiode. Besides, it emits light of a short wavelength because of its containment of Ce or/and Eu. Thus, it can also be combined with a photomultiplier tube.

In Patent Document 2, the inventors have proposed a neutron detection scintillator composed of a colquiriite-type fluoride monocrystal containing at least two rare earth elements and also containing 0.80 atom/$nm^3$ or more of $^6$Li. The scintillator of Patent Document 2 emits light of a short wavelength by containing Ce and/or Eu as a rare earth element. Thus, it can be combined with a photomultiplier tube. Besides, it contains a rare earth element other than Ce or Eu, thereby emitting light of a long wavelength. Thus, it can also be combined with a silicon photodiode.

In Patent Document 3, the inventors have proposed a scintillator comprising a metal fluoride crystal containing lithium and a metallic element having a valence of 2 or higher, the crystal containing 1.1 to 20 atoms/$nm^3$ of $^6$Li, having an effective atomic number of 10 to 40, and containing a lanthanoid such as Eu.

The scintillators of Patent Documents 1 to 3 can be combined with silicon photodiodes, and hardly cause light emission ascribed to gamma rays. However, none of Patent Documents 1 to 3 have considered increasing detection efficiency for a neutron by thickening the scintillator.

The efficiency of detecting neutron radiation depends on a plurality of factors such as the ratio of neutrons causing a nuclear reaction among neutrons irradiated; whether or not alpha rays generated by the reaction between neutrons and $^6$Li are absorbed within the scintillator; and whether or not light generated by the reaction between alpha rays and the luminescence center elements is decreased by concentration quenching.

When the thickness of the scintillator is increased, therefore, the performance of the scintillator is not necessarily enhanced as compared with when the scintillator is thin. This is because it is highly likely that the efficiency of detection will be decreased, or performance other than the detection efficiency will be lowered, by the influence of concentration quenching, ease of processing, transparency of the crystal constituting the scintillator, and so forth. Hence, it remains difficult to predict what features the resulting scintillator will have, before investigating appropriate constituent elements, the type of the crystal which forms a basic structure, thickness and so on preparing a scintillator actually, and further evaluating the various performance characteristics of the scintillator.

Prior Art Documents:

Patent Documents:

Patent Document 1: PCT/JP2012/052526
Patent Document 2: PCT/JP2012/052527
Patent Document 3: WO2009/119378

Non-Patent Documents:

Non-Patent Document 1: J. Schelten, etc., PhysicaB: Condensed Matter, 234-236, (1997) 1084-1086
Non-Patent Document 2: K. Nittoh, etc., Nuclear Instruments and Methods in Physics Research Section A Accelerators, Spectrometers, Detectors and Associated Equipment, 605, Issues 1-2 (2009) 107-110

Summary of the Invention:

Problems to be solved by the invention:

It is an object of the present invention to provide a compact, lightweight neutron detection device having a sufficiently high neutron detection efficiency and equipped with a neutron detection scintillator minimally affected by gamma rays.

Means for solving the problems:

The present inventors have conducted in-depth studies in an attempt to solve the above-mentioned problems. As a result, they have found that when a colquiriite-type fluoride single crystal incorporating a specific amount of Eu is combined with a siliconphotodiode, fluorescence produced by the single crystal can be unexpectedly received by the silicon photodiode, although its wavelength is as short as about 370 nm. The reason may be that the emission intensity of the short-wavelength light is high. Moreover, the single crystal has a lower effective atomic  number than those of the conventional scintillators. Thus, a neutron detection device comprising a combination of a scintillator composed of the single crystal and a silicon photodiode has low sensitivity to gamma rays, and can be used as a neutron detector. Furthermore, it has been found that when the content of Eu is set in a certain range and the thickness of the scintillator is increased, the detection efficiency for a neutron is heightened.

According to the present invention, there is provided a neutron detection device equipped with a neutron detection scintillator composed of a colquiriite-type fluoride single crystal, and a silicon photodiode,
wherein the single crystal includes only Eu and contains 0.80 atom/$nm^3$ or more of $^6Li$,
the content of Eu is 0.0025 to 0.05 mol%, and the thickness of the scintillator exceeds 1 mm.

In the neutron detection device of the present invention, it is preferred that the single crystal contains Eu in a basic single crystal of a composition represented by $LiCaAlF_6$, $LiSrAlF_6$ or $LiCa_{1-x}Sr_xAlF_6$ (0<x<1).

Effects of the invention:

The present invention concerns a neutron detection device equipped with a neutron detection scintillator composed of a colquiriite-type fluoride single crystal, and a silicon photodiode, wherein the single crystal contains only Eu as a rare earth element, and contains 0.80 atom/$nm^3$ or more of $^6Li$, the Eu content is 0.0025 to 0.05 mol%, and the thickness of the scintillator is large. The silicon photodiode is compact and lightweight. Thus, the neutron detection device is useful as a compact, lightweight neutron detection device, and is preferred for applications, such as a survey meter for use in the  determination of whether or not a neutron is present in the environment.

Brief Description of the Drawings:

[Fig. 1] is a schematic view of an apparatus for manufacturing a crystal used for a scintillator according to the present invention by the Czochralski method.
[Fig. 2] is a schematic view of a neutron detection device according to the present invention.
[Fig. 3] is a view of the current-voltage characteristics of a neutron detection device of Example 1 when irradiated with, and shielded from, thermal neutrons.
[Fig. 4] is a view of the pulse height spectra of the neutron detection device of Example 1 when irradiated with, and shielded from, thermal neutrons.
[Fig. 5] is a view of the pulse height spectra of a neutron detection device of Comparative Example 1 when irradiated with, and shielded from, thermal neutrons.
[Fig. 6] is a view of the pulse height spectra of a neutron detection device of Comparative Example 2 when irradiated with, and shielded from, thermal neutrons.
[Fig. 7] is a view of the pulse height spectra of a neutron detection device of Comparative Example 3 when irradiated with, and shielded from, thermal neutrons.

Mode for Carrying Out the Invention:

The neutron detection device of the present invention comprises a scintillator having a thickness in excess of 1 mm and a silicon photodiode, the scintillator being composed of a colquiriite-type fluoride single crystal which contains only Eu as a lanthanoid, contains 0.80 atom/$nm^3$ or more of $^6Li$, and has a Eu content of 0.0025 to 0.05 mol%.

The term "colquiriite" refers to a naturally occurring  $LiCaAlF_6$ compound, which has a characteristic crystal structure. The colquiriite type, as referred to herein, embraces a compound having a structure similar to that of colquiriite in which some elements of the compound have been substituted by other elements.

In the present invention, the colquiriite-type fluoride single crystal is preferably exemplified by a crystal having, as a basic structure, a single crystal of a compound represented by the chemical formula $M^XM^YM^ZF_6$ (the exemplary crystal will hereinafter be referred to as a colquiriite-type basic crystal) . In the chemical formula, $M^X$ is at least one element selected from the group consisting of Li, Na, K, Rb and Cs, but necessarily includes Li. $M^Y$ is at least one element selected from the group consisting of Ca, Mg, Ba, Sr, Cd and Be. $M^Z$ is at least one element selected from the group consisting of Al, Ga and In. $M^X$ includes, without fail, Li necessary to detect a neutron. If charge control is to be performed, moreover, $M^X$ preferably contains Na.

The colquiriite-type single crystal is a hexagonal crystal belonging to the space group P31c, and can be easily identified by a technique for powder X-ray diffraction.

Of the colquiriite-type basic crystals, single crystals of a compound represented by the chemical formula $LiCaAlF_6$, $LiSrAlF_6$ or $LiCa_{1-x}Sr_xAlF_6$ (0<x<1) are preferred, because they are easy to produce as large crystals, and obtain high emission intensity when used as scintillators. Of them, $LiCaAlF_6$ is the most preferred, because its effective atomic number is so small that its sensitivity to gamma rays is low.

In the present invention, the effective atomic number is an indicator defined by the following equation:

$$\text{Effective atomic number } = (\Sigma W_i Z_i{}^4)^{1/4}$$

where

W_i represents the mass fraction of the ith element among the elements constituting the scintillator, and
Z_i represents the atomic number of the ith element among the elements constituting the scintillator.

The $^6Li$ content of the colquiriite-type fluoride single crystal used in the present invention needs to be 0.80 atom/nm$^3$ or more from the viewpoint of obtaining sensitivity to a neutron, the sensitivity required for a neutron detection scintillator. To enhance the sensitivity to a neutron, moreover, it is preferred that the $^6Li$ content be set at 4 atoms/nm$^3$ or more.

The upper limit of the $^6Li$ content is 9 atoms/nm$^3$. The $^6Li$ content in the colquiriite-type fluoride single crystal is theoretically of the order of 9 atoms/nm$^3$ at the highest, and it is impossible to obtain the colquiriite-type fluoride single crystal having a higher $^6Li$ content than this value.

The $^6Li$ content, as used herein, refers to the number of the Li elements contained per nm$^3$ of the colquiriite-type fluoride single crystal used in the present invention. The incident neutrons cause a nuclear reaction with $^6Li$ to produce alpha rays. Thus, the $^6Li$ content influences the sensitivity to neutrons and, the higher the $^6Li$ content, the higher the sensitivity to neutrons becomes.

The $^6Li$ content can be adjusted, as appropriate, either by selecting a suitable composition of the crystal compounds constituting the basic structure of the neutron detection scintillator, or by adjusting the $^6Li$ abundance ratio of LiF or the like used as the Li material. The $^6Li$ abundance ratio, as used herein, refers to the element ratio of $^6Li$ isotope to all Li elements, and its natural abundance ratio is about 7.6%. Examples of methods for adjusting the $^6Li$ abundance ratio are a method which comprises using a general-purpose material with the natural abundance ratio as a starting material, and concentrating the starting material to the desired $^6Li$ abundance ratio for adjustment; and a method which comprises having, ready for use, a concentrated material concentrated beforehand to the desired $^6Li$ abundance ratio or higher, and mixing the concentrated material and the above general-purpose material for adjustment.

The $^6Li$ content (atoms/nm$^3$) can be determined by the following [Equation 1]:

$$^6\text{Li content } = A \times C \times \rho \times 10^{-23}/M \qquad \text{[Equation 1]}$$

where

A is Avogadro's number [6.02x10$^{23}$],
C is the $^6Li$ abundance ratio [%] in the Li elements,
$\rho$ is the density [g/cm$^3$] of the colquiriite-type fluoride single crystal used in the present invention, and
M is the molecular weight [g/mol].

The colquiriite-type fluoride single crystal used in the present invention is a colorless or slightly colored transparent crystal, and has satisfactory chemical stability. When it is used for a short period under ordinary use conditions, its performance does not deteriorate. Furthermore, its mechanical strength and processability are satisfactory, and it can be easily processed into a desired shape.

The scintillator used in the present invention can be increased in the detection sensitivity for a neutron by having its thickness increased. The thickness of the scintillator, as used herein, refers to the length of the scintillator in a direction perpendicular to a surface of the scintillator bonded to the light receiving surface of the silicon photodiode. The scintillator is preferably in the form of a rectangular parallelepiped or a cube in which the length of the shortest side is more than 1 mm, or in the form of a disk or a cylinder having a length, in a direction perpendicular to the circle, of more than 1 mm. Moreover, a thickness of 1.5 mm or more, 2 mm or more, 4 mm or more, or 10 mm or more is more preferred, because such a thickness can increase the probability of the nuclear reaction between neutrons and $^6$Li and can further enhance the detection efficiency for neutrons. The increased thickness also increases the probability for the occurrence of the nuclear reaction between neutrons and $^6$Li, thus producing the advantage that not only a thermal neutron of low energy, but also a neutron of higher energy than a thermalneutron, e.g., an epithermalneutron, can also be detected. As the thickness is increased, however, there is an increase in the area of a portion not bonded to the light receiving surface of the silicon photodiode. Fluorescence leaks from this portion, and the efficiency of concentrating the emitted light on the light receiving surface of the silicon photodiode is diminished. Thus, the upper limit of the thickness is preferably of the order of 200 mm. The conventionally known $^6$LiF film involves the problem of absorbing alpha rays inside it, and cannot be thickened as is the scintillator of the present invention. The scintillator of the present invention is free from this problem, because alpha rays generated by the nuclear reaction are promptly converted into light upon reaction with the luminescence center elements. Thus, the scintillator of the present invention is very beneficial in that a high neutron detection efficiency is obtained and an epithermal neutron is also detectable.

The relation between the thickness of the scintillator of the present invention and the probability of the nuclear reaction is concretely calculated as follows:

Assume that the scintillator containing $^6$Li in an amount of the order of 9 atoms/nm$^3$ is irradiated with 0.025 eV of thermal neutrons. In this case, the reaction cross-section of this scintillator for the reaction between $^6$Li and neutrons is 940 barns. Under these conditions, the probability of neutrons causing a nuclear reaction with $^6$Li among the neutrons irradiated is calculated at about 60% when the thickness of the scintillator is 1 mm. The probability at a thickness of 1.5 mm is about 70%, the probability at a thickness of 2 mm is about 80%, and the probability at a thickness of 4 mm is about 90%. Generally, the scintillator with the probability of nuclear reaction exceeding 50% is suitable for practical use.

However, if the $^6$Li content in the scintillator is decreased, or if the object for detection is expanded up to a neutron with high energy, for example, an epithermal neutron of about 1 eV, it is preferred to impart a thickness greater than the above values to the scintillator. If the scintillator of the present invention containing 9 atoms/nm$^3$ of $^6$Li is assumed to be irradiated with 1 eV of epithermal neutrons, the reaction cross-section of this scintillator for reaction between $^6$Li and neutrons of 1 eV is 188 barns. Under these conditions, with the thickness of the scintillator being 10 mm, the probability of neutrons causing a nuclear reaction with $^6$Li among the neutrons irradiated can be calculated at about 70%.

The colquiriite-type fluoride single crystal used in the present invention contains Eu element in the aforementioned colquiriite-type basic crystal. The Eu element is presumed to be present in interstitial site of the colquiriite-type basic crystal, or to be present as replacing some of the elements constituting the crystal, but its exact form of existence is unknown. Since this element is contained, alpha rays generated by the reaction between neutrons and $^6$Li react with the Eu element, obtaining light emission containing light in a wavelength region of about 370 nm. The silicon photodiode generally has maximum sensitivity to light in a wavelength region of about 900 nm, but has low sensitivity to light in a short wavelength region. Thus, it is expected that the silicon photodiode will face much difficulty in receiving light with a short wavelength of about 370 nm. Nonetheless, with the present invention, when a scintillator comprising a colquiriite-type fluoride single crystal containing Eu is combined with a silicon photodiode, this diode can receive fluorescence emitted by the scintillator. This may be because the intensity of light in a wavelength region of about 370 nm emitted by the scintillator of the present invention is high.

The content of the Eu element in the colquiriite-type fluoride single crystal used in the present invention is 0.0025 mol% or more per mol of the colquiriite-type fluoride single crystal used in the present invention, from the viewpoint of obtaining a sufficient amount of light emission at the time of irradiation with neutrons. Moreover, the content of the Eu element is 0.05 mol% or less, from the points of view that a single crystal is easy to grow and that a neutron with high energy, such as an epithermalneutron, can also be detected. If the content of the Eu element is too high, cloudiness is liable to occur in the single crystal, making crystal growth difficult. Growth of a thick crystal also becomes difficult, making it impossible to produce a scintillator enough thick to be capable of detecting a neutron of high energy.

In the present invention, the content of the Eu element is within the above-mentioned range. Even when the thickness of the scintillator is increased, therefore, the amount of light emitted does not decrease greatly, and variations in the signal strength are suppressed. If the content of the Eu element is increased beyond the above range, the amount of light emission greatly decreases, and the signal strength fluctuates, when the thickness of the scintillator is increased.

That is, in the present invention, the above amount of Eu is used and, at the same time, the thickness of the scintillator is increased, from the viewpoints of increasing the detection efficiency for a thermal neutron and detecting a neutron of high energy. Generally, when a large amount of Eu is present within the scintillator, the distance between the Eu atoms is short. In a thin scintillator, the short distance between the Eu atoms poses no problem. If the scintillator is thick, on the other hand, its performance as a detection device deteriorates owing to the influence of the phenomenon "self-absorption" in which the fluorescence is attenuated.

Concretely, if fluorescence occurs upon the reaction between Eu and alpha rays, at a position within the scintillator which is distant from the silicon photodiode, this fluorescence collides with other Eu element during passage within the scintillator, and is thus attenuated. Hence, at a time when the fluorescence is received by the diode, emission intensity lowers. Fluorescence generated at a position close to the diode, by contrast, arrives at the diode immediately, so that the fluorescence is minimally attenuated, and its emission intensity is high. As noted here, depending on the position of light emission, the intensity of light received by the silicon photodiode greatly differs, and the pulse height values of electrical signals from the silicon photodiode are also greatly different. The differences in the pulse height values of the electrical signals bring about inconveniences such that the range of the pulse height values showing the detection of neutrons must be set to be broad, and that a long time is required until a detection peak is obtained.

The colquiriite-type fluoride single crystal used in the present invention contains only Eu as a lanthanoid, and does not contain transition metals or other rare earth elements. In the present invention, transition metals mean Ti, V, Cr, Mn, Fe, Co, Ni, Cu and Zn, and other rare earth elements mean Ce, Pr, Nd, Er, Tm, Ho, Dy, Tb, Gd, Sm, Yb, La, Lu, Y, Sc and Pm. The reason why only Eu is contained is that if a luminescence center element other than Eu is further contained, a disadvantage arises such that light emission due to Eu is liable to decrease.

During the production process for the colquiriite-type fluoride single crystal to be described later, segregation of Eu may occur. Even in such a case, an effective segregation coefficient (k) is determined preliminarily and, based on the following equation [Equation 2]:

$$C_S = kC_O(1-g)^{k-1} \qquad [\text{Equation 2}]$$

where

$C_S$ is the content [mol%] of Eu in the colquiriite-type fluoride single crystal used in the present invention, k is the effective segregation coefficient,
$C_O$ is the amount [mol%] of Eu in the raw materials, and
g is the solidification rate,

the Eu content in the raw materials (value of $C_O$) is adjusted. By so doing, the colquiriite-type fluoride single crystal containing the desired amount of Eu can be easily obtained.

The solidification rate, as used herein, is an indicator representing a position in the growth direction of a crystal, and is determined by the ratio of the weight of a solidified portion to the weight of the raw materials as a whole. That is, the position corresponding to the solidification rate of 0 represents the initially crystallizedportion of the resulting crystal, and the position for the solidification rate of 0.1 represents the portion crystallized using up to 10 wt.% of the weight of the entire melt of the materials. The Czochralski method normally crystallizes 30 wt.% or less of the molten materials. In a crystal produced by crystallizing 30 wt.% of the molten materials by the Czochralski method, for example, the position for the solidification rate of 0 corresponds to the uppermost portion of the crystal, and the position for the solidification rate of 0.3 corresponds to the lowermost portion of the crystal.

As the effective segregation coefficient, the value described in the literature (e.g., Growth of Ce-doped LiCaAlF$_6$ and LiSrAlF$_6$ single crystals by the Czochralski technique under CF$_4$ atmosphere) maybe adopted. Since the effective segregation coefficient fluctuates depending on the growth method, however, it is preferred to use the value determined preliminarily. According to measurements by the present inventors, for example, the effective segregation coefficient of Eu for LiCaAlF$_6$ obtained by the Czochralski method was 0.025.

The content (mol%) of Eu in the actual crystal can be confirmed by a general method for elemental analysis (for example, ICP mass spectrometry or ICP atomic emission spectroscopy).

The method of producing the colquiriite-type fluoride single crystal used in the present invention is not limited, and the crystal can be produced by a publicly known method. Preferably, however, the crystal is produced by the Czochralski method. A colquiriite-type fluoride single crystal excellent in quality, such as transparency, can be produced by adopting the Czochralski method. According to the Czochralski method, moreover, it becomes possible to produce a large crystal of several inches in diameter.

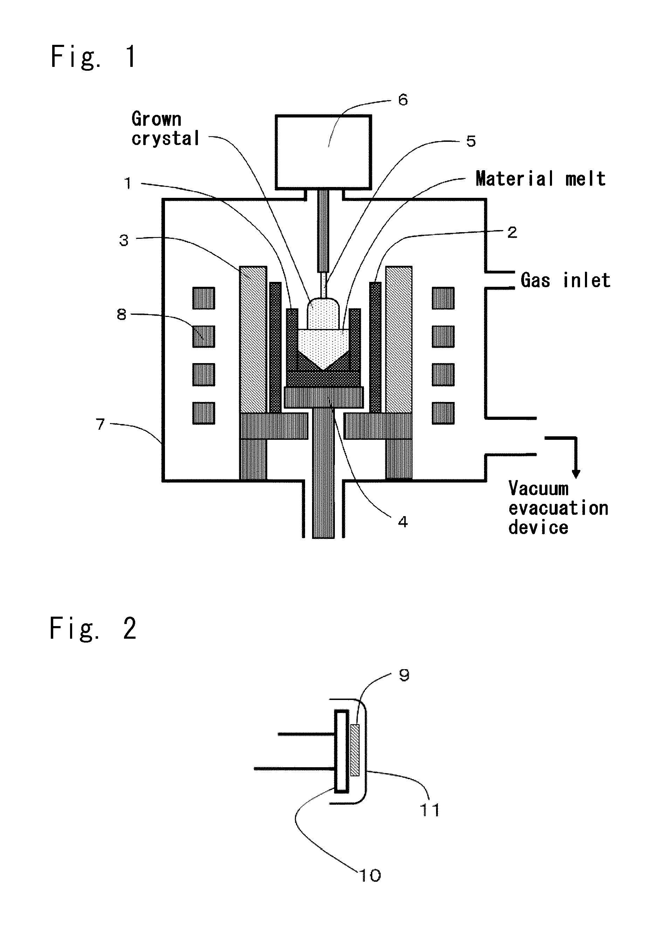

A general method in producing the colquiriite-type fluoride single crystal for use in the present invention by the Czochralski method will be explained based on Fig. 1.

In producing the colquiriite-typefluoridesingle crystal used in the present invention, it is preferred to use EuF$_3$, M$^X$F, M$^Y$F$_2$ and M$^Z$F$_3$ as the raw materials. The purities of these materials are not limited, but they are preferably 99.99% or higher, respectively. Moreover, it is preferred to use a material mixture formed by mixing these materials beforehand.

By using such a material mixture, the purity of the resulting crystal can be increased, and the characteristics such as emission intensity are improved. The material mixture may be used in powdery or particulate form, or may be used after being sintered or melt-solidified beforehand.

As the material for LiF which must be contained in $M^X F$, it is preferred to use a concentrate of $^6$Li, because this makes it easy to adjust the $^6$Li content in the colquiriite-type fluoride single crystal. A concentration to be achieved by the concentrating operation is not limited, as far as it is such a concentration as to render the $^6$Li content of the scintillator 0.8 atom/nm$^3$ or more. The higher the $^6$Li content in the scintillator, however, the more increase is obtained in the neutron detection efficiency of the grown crystal for use as the neutron detection scintillator. Thus, such a concentration of the concentrated $^6$Li as to increase the content of $^6$Li in the scintillator is preferred.

In the above-mentioned material mixture, it is recommendable that $M^X F$, $M^Y F_2$ and $M^Z F_3$ be weighed and mixed to attain the $M^X$:$M^Y$:$M^Z$=1:1:1 ratio (molar ratio).

EuF$_3$ is blended so as to attain the content in the aforementioned range. Concretely, the weighed value of EuF$_3$ is preferably set to be higher than the targeted content of the Eu element in consideration of the aforementioned segregation. The segregation coefficient used when calculating the contents of the added elements in the resulting crystal from the weighed value varies depending on the growth conditions such as the types of the added elements and the growth speed. Thus, it is desirable to determine the weighed value of EuF$_3$ by investigating the actual concentration by means of elemental analysis or the like for respective crystal preparation conditions.

If material powders highly volatile at high temperatures are used, the material powders may be weighed in larger amounts than the targeted contents, and mixed. Their amounts of volatilization differ depending on crystal growth conditions (temperature, atmosphere, step). Desirably, therefore, the amounts of volatilization should be investigated beforehand, and the amounts blended should be determined.

The above-mentioned raw materials are charged into a crucible 1. The crucible 1, a heater 2, a heat insulator 3, and a movable stage 4 are installed as shown in Fig. 1. A double crucible setup maybe adopted by mounting another crucible, which has a hole provided at the bottom, above the crucible 1, and fixing it to the heater 2 or the like while suspending it therefrom.

Then, a seed crystal 5 is mounted on the front end of an automatic diameter control device 6. A metal having a high melting point, such as platinum, may be used instead of the seed crystal 5. However, it is preferred to use a colquiriite-type fluoride single crystal or a single crystal having a crystal structure similar to that of the colquiriite-type fluoride single crystal, from the viewpoint that the crystallinity of a grown crystal is satisfactory. For example, it is possible to use a LiCaAlF$_6$ single crystal which has been cut, ground and polished in the form of a rectangular parallelepiped of a size of the order of 6 mm x 6 mm x 30 mm in which the side measuring 30 mm extends along the c-axis direction. The automatic diameter control device 6 is a device for measuring the total weight of the seed crystal 5 and the grown crystal, and adjusting the pulling rate of the seed crystal 5 based on the measured value. By adjusting the pulling rate, the diameter of the grown crystal can be controlled. With the device 6, a load cell for a pulling-up device, which is commercially available for crystal growth by the Czochralski method, can be used.

Then, by using a vacuum evacuator, the interior of a chamber 7 is evacuated to $1.0 \times 10^{-3}$ Pa or lower. Then, an inert gas such as high purity argon is introduced into the chamber for gas exchange. The pressure within the chamber after the gas exchange is not limited, but is generally atmospheric pressure. By this gas exchange operation, water adhering to the starting materials or the interior of the chamber can be removed, and the deterioration of the crystal due to such water can be prevented.

To avoid adverse influence due to water which cannot be removed even by the above gas exchange operation, it is preferred to use a solid scavenger such as zinc fluoride, or a gas scavenger such as tetrafluoromethane. If the solid scavenger is used, a method comprising premixing this scavenger into the raw materials is preferred. If the gas scavenger is used, a method involving introducing the scavenger, as a mixture with the above inert gas, into the chamber is preferred.

After the gas exchange operation is performed, the materials are heated by a high frequency coil 8 and the heater 2 until they are melted. The method of heating is not limited, and a resistance heating type carbon heater or the like, for example, may be used, as appropriate, in place of a configuration composed of the high frequency coil 8 and the heater 2.

Then, the molten material melt is brought into contact with the seed crystal 5. The heater 2 is adjusted by the output of the high frequency coil 8 such that a portion of the melt in contact with the seed crystal 5 is brought to a solidification temperature. Then, with the pulling rate being adjusted by the automatic diameter control device 6, the crystal is pulled upward. During crystal growth, the movable stage 4 may be moved upward or downward, as appropriate, in order to adjust the height of the liquid level. The crystal is continuously pulled up, with the output of the high frequency coil being adjusted where appropriate. When the crystal grows to the desired length, the crystal is cut off the liquid surface. The grown crystal is cooled over the course of such a sufficient time as to avoid cracking therein, whereby a colquiriite-type fluoride single crystal for use in the present invention can be obtained.

In the production of the colquiriite-type fluoride single crystal, annealing of the grown crystal may be performed for the purpose of eliminating a crystal defect due to a fluorine vacancy or thermal strain.

The resulting colquiriite-type fluoride single crystal can be easily processed into a desired shape. In processing it, a cutter such as a blade saw or a wire saw, a grinder or an abrasive wheel, which is publicly known, can be used without limitation. By processing and polishing the single crystal into a shape appropriate for a photodetector, it can be used as a scintillator.

The shape of the scintillator comprising the colquiriite-type fluoride single crystal according to the present invention is not limited, but preferably, this scintillator has an optical output surface opposing a silicon photodiode to be described later. In the scintillator, the thickness in the direction perpendicular to the optical output surface needs to exceed 1 mm in order to obtain sufficient neutron detection efficiency. In accordance with the purpose of the neutron detection device, moreover, the thickness of the scintillator may be set at 1.5 mm or more, 2 mm or more, 4 mm or more, or 10 mm or more. The optical output surface has preferably been subjected to optical polishing. By having such an optical output surface, light generated by the scintillator can be efficiently admitted into the silicon photodiode.

The shape of the optical output surface is not limited, and a shape adapted for applications can be appropriately selected and used, such as a quadrilateral shape measuring several millimeters to several hundred millimeters per side, or a circular shape with a diameter of several millimeters to several hundred millimeters. However, the optical output surface of any appropriate shape is preferably smaller than the light receiving surface of the silicon photodiode, because light emission dissipating without reaching the light receiving surface is minimal.

Preferably, a light reflection film comprising aluminum, Teflon (registered trademark) or the like is applied to surfaces of the scintillator which do not oppose the silicon photodiode. By so doing, dissipation of light generated by the scintillator can be prevented.

The colquiriite-type fluoride single crystal used in the present invention, which has been produced in the above-mentioned manner, is combined with a silicon photodiode, whereby the neutron detection device of the present invention is constructed.

That is, light emitted from the neutron detection scintillator of the present invention upon irradiation with neutron radiation (i.e., scintillation light) is converted into an electrical signal by the silicon photodiode, whereby the presence or absence and strength of a neutron can be grasped as the electrical signal.

As the silicon photodiode, any one can be used. From the viewpoint that light from the scintillator can be received with high sensitivity, however, it is preferred to use an APD (avalanche photodiode) having the function of amplifying an electrical signal. As an example, the avalanche photodiode S8664 series produced by Hamamatsu Photonics K.K. can be used.

The optical output surface of the neutron detection scintillator of the present invention is bonded to the light receiving surface of the silicon photodiode with the use of any optical grease or the like, whereby a neutron detection device can be obtained. The light receiving surface of the diode having the scintillator bonded thereto maybe covered with a light shield of anymaterial impervious to light, for the purpose of preventing entry of light from the environment. Portions of the scintillator, other than the bonded surface opposing the light receiving surface of the silicon photodiode, may be covered with a reflector composed of aluminum, Teflon (registered trademark), or barium sulfate for increased light concentrating efficiency. Alternatively, the entire detection device may be covered with a material having the functions of both the light shield and the reflector mentioned above. Observation of electrical signals outputted from the silicon photodiode enables the detection of neutrons to be confirmed.

The electrical signal outputted from the silicon photodiode may be inputted to an amplifier, a multichannel pulse height analyzer or the like, and measured by photon counting. Alternatively, the silicon photodiode may be connected to any current measuring device (e.g., picoammeter) to investigate changes in the current so that a change in the current value responsive to a change in the amount of light received can be confirmed. At this time, in order to increase light receiving sensitivity, voltage may be applied, in reverse bias, to the silicon photodiode. In this case, any measuring device capable of applying voltage or current and making measurements simultaneously (for example, KEITHLEY 237 HIGH VOLTAGE SOURCE MEASURE UNIT) may be employed. The value of voltage applied is preferably set according to the performance of the silicon photodiode or the flux of neutrons to be measured. If the avalanche photodiode S8664 series produced by Hamamatsu Photonics K.K. is used, for example, it is particularly preferred to apply a voltage of 300 to 400 V. At the operating voltage set, the relation between the flux of thermal neutrons irradiated and the current value is measured beforehand. By so doing, the neutron detection device can be used as a quantitative one.

Furthermore, the crystal of the present invention is joined to a position-sensitive silicon photodiode, as in a pixel APD or a CCD camera, so as to cover a part or all of the photoelectric surface, whereby a neutron imaging device can be constituted. Electrical signals from the position-sensitive silicon photodiode can be read out by using any interface, and may be controlled by using a control program of a personal computer.

Examples:

Hereinbelow, the present invention will be described concretely by reference to its Examples, but the present invention is in no way limited by these Examples.

Example 1

(Production of neutron detection device)

A method for producing the neutron detection device of the present invention, which was used in Example 1, will be described below.

Using the crystal production apparatus by the Czochralski method shown in Fig. 1, a colquiriite-type fluoride single crystal for use in the present invention was produced. High purity fluoride powders of LiF, $CaF_2$, $AlF_3$ and $EuF_3$, each having purity of 99.99% or higher, were used as raw materials. As the LiF, a product with a $^6$Li abundance ratio of 95% was used. The crucible 1, the heater 2, and the heat insulator 3 used were formed of high purity carbon.

First, the respective materials were weighed in the following manner

| | |
|---|---|
| LiF | 393.1 g, |
| $CaF_2$ | 1224.4 g, |
| $AlF_3$ | 1317.0 g, and |
| $EuF_3$ | 65.5 g, |

and they were mixed thoroughly to obtain a material mixture. The material mixture was charged into the crucible 1.

The crucible 1 charged with the material mixture was installed on the movable stage 4, whereafter the heater 2 and the heat insulator 3 were sequentially installed around the crucible 1. Then, a $LiCaAlF_6$ single crystal was cut, ground and polished into the form of a rectangular parallelepiped measuring 6 mm × 6 mm × 30 mm, with the 30 mm side extending along the c-axis direction, to obtain the seed crystal 5. The seed crystal 5 was mounted on the front end of the automatic diameter control device 6.

The interior of the chamber 6 was evacuated under vacuum to $5.0 \times 10^{-4}$ Pa by use of a vacuum evacuation device composed of an oil-sealed rotary vacuum pump and an oil diffusion pump. Then, a tetrafluoromethane-argon mixed gas was introduced into the chamber 7 until the pressure inside the chamber reached atmospheric pressure, to perform gas exchange.

A high frequency current was applied to the high frequency coil 8 to heat the materials by induction heating, there by melting them. The seed crystal 5 was moved until it was brought into contact with the liquid surface of the material melt. The output of the heater 2 was adjusted such that a portion of the melt in contact with the seed crystal 5 came to a solidification temperature. Then, the crystal was pulled upward at a pull rate automatically adjusted by the automatic diameter control device 6, with a crystal diameter of 55 mm being targeted.

The movable stage 4 was moved, as appropriate, in order to adjust the liquid level to a constant position, and the crystal was continuously pulled up, with the output of the high frequency coil being adjusted where appropriate. When the crystal grew to a length of 60 mm, the crystal was cut off the liquid surface. The crystal was cooled over 48 hours to obtain a Eu-containing $LiCaAlF_6$ single crystal with a diameter of 55 mm and a length of 60 mm.

The resulting crystal was cut by a wire saw equipped with a diamond wire. Then, the cut piece was ground and mirror polished to be processed into the form of a rectangular parallelepiped 10 mm long, 10 mm wide and 2 mm thick.

The above crystal after processing was cut out of the portion with a Eu content $C_S$ of 0.05 mol% (the portion having a solidification rate g of 0.01 corresponding to the initial stage during single crystal growth) according to the aforementioned [Equation 2], to obtain the scintillator of the present invention. The amount of Eu in the materials, i.e., $C_O$, was 2 mol%, and the value of the effective segregation coefficient k was 0.025. From the aforementioned [Equation 1], the $^6$Li content in this portion was 8.3 atoms/nm$^3$. The effective atomic number was 15.

As shown in Fig. 2, the resulting neutron detection scintillator 9 was bonded to a light receiving surface of a silicon photodiode 10 (S8664-1010 produced by Hamamatsu Photonics K.K.) with the use of an optical grease (6262A produced by OHYO KOKEN KOGYO CO., LTD.), and the entire system was covered with a light shield 11 composed of a black vinyl sheet, to construct a neutron detection device according to the present invention.

Then, a test for detection of a thermal neutron was conducted by using the neutron detection device of the present invention. A $^{252}$Cf sealed radiation source placed in a 50 mm thick polyethylene container was used as a thermal neutron source. Current-voltage characteristics and pulse height spectra were measured under irradiation with thermal neutrons with no material being inserted between the thermal neutron source and the detection device (hereinafter called "during thermal neutron irradiation"), and under irradiation with thermal neutrons with a shielding plate being inserted between the thermal neutron source and the detection device (hereinafter called "during thermal neutron shielding"). A 1 mm plate of Cd (cadmium) absorbing a thermal neutron was used as the shielding plate.

(Measurement of current-voltage characteristics)

Using the neutron detection device of the present invention, the current-voltage characteristics during thermal neutron irradiation and those during thermal neutron shielding were compared.

The neutron detection device was connected to an ammeter and used. The ammeter used was KEITHLEY 237 HIGH VOLTAGE SOURCE MEASURE UNIT which can read off a current value while applying a voltage. While applying a voltage of 300 to 400 V in reverse bias under a control program on a personal computer, this ammeter measured the current value, and plotted a graph of the current-voltage characteristics.

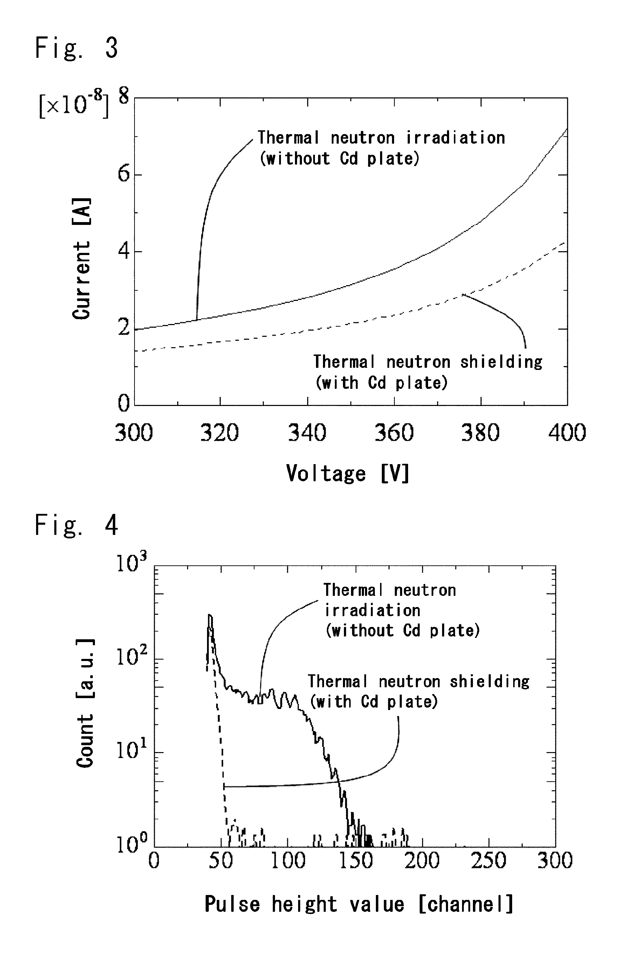

The aforementioned $^{252}$Cf sealed radiation source placed in the polyethylene container was used as a thermal neutron source. Fig. 3 shows the current-voltage characteristics during thermal neutron irradiation and those during thermal neutron shielding. The current values during thermal neutron irradiation were greater than the values during shielding. The current value at 350 V, for example, was $2.13 \times 10^{-8}$ A during thermal neutron shielding, but was $3.14 \times 10^{-8}$ A during thermal neutron irradiation. These findings demonstrated that the current value increased as the flux of thermal neutrons increased.

The above results confirmed that thermal neutrons could be detected by the neutron detection device of the present invention based on the simple, easy measurements of the current-voltage characteristics.

(Measurement of pulse height spectrum)

Using the neutron detection device of the present invention, pulse height spectra during thermal neutron irradiation and during thermal neutron shielding were compared.

The aforementioned $^{252}$Cf sealed radiation source placed in the polyethylene container was used as a thermal neutron source. The pulse height spectra were measured, with a voltage of 3.2 V being applied in reverse bias.

Electrical signals outputted from the neutron detection device of the present invention are pulsed signals reflecting scintillation light. The pulse heights of the pulses represent the emission intensities of scintillation light. The waveform of the pulses shows a decay curve based on the decay constant of scintillation light. The electrical signals outputted were shaped and amplified by a shaping amplifier, and then entered into a multichannel pulse height analyzer for analysis, to prepare a pulse height spectrum.

Fig. 4 shows the pulse height spectra during thermal neutron irradiation and during thermal neutron shielding.

The abscissa of the pulse height spectrum represents the pulse height value of the electrical signal, namely, the emission intensity of scintillation light. The ordinate represents the frequency of the electrical signal showing each pulse height value.

Comparative Example 1

A neutron detection device was produced in the same manner as in Example 1, except that the respective materials were weighed in the following manner

| | |
|---|---|
| LiF | 397.7 g, |
| $CaF_2$ | 1238.7 g, |
| $AlF_3$ | 1332.4 g, and |
| $CeF_3$ | 31.3 g, |

and that the resulting crystal was cut out of the portion with a Ce content $C_S$ of 0. 04 mol% (the portion having a solidification rate g of 0.01 corresponding to the initial stage during single crystal growth) according to the aforementioned [Equation 2]. The amount of Ce in the materials, i.e., $C_O$, was 1 mol%, and the value of the effective segregation coefficient k was 0.04. In the device, a scintillator composed of the single crystal Ce0.04%:LiCaAlF$_6$ was used. The effective atomic number was 15.

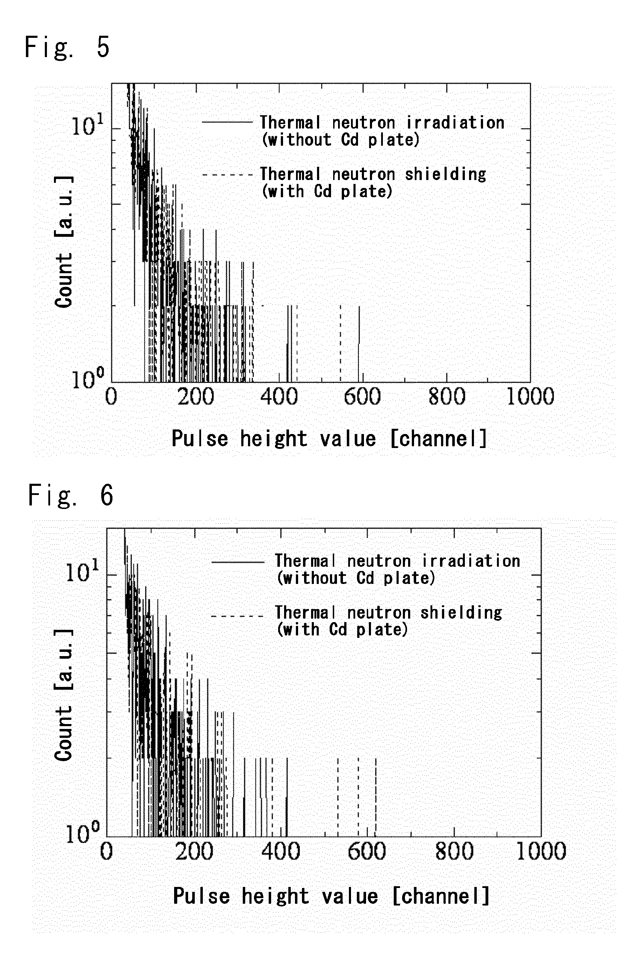

Pulse height spectra during thermal neutron irradiation and during thermal neutron shielding were obtained in the same manner as in Example 1, except that the pulse height spectra were measured using the resulting neutron detection device, with a voltage of 310 V being applied in reverse bias. Fig. 5 shows the resulting pulse height spectra.

Comparative Example 2

A neutron detection device was produced in the same manner as in Example 1, except that the respective materials were weighed in the following manner

|      |            |
| ---- | ---------- |
| LiF  | 397.6 g,   |
| $CaF_2$ | 1238.7 g, |
| $AlF_3$ | 1332.3 g, and |
| $PrF_3$ | 31.4 g,   |

and that the resulting crystal was cut out of the portion with a Pr content $C_S$ of 0. 04 mol% (the portion having a solidification rate g of 0.01 corresponding to the initial stage during single crystal growth) according to the aforementioned [Equation 2]. The amount of Pr in the materials, i.e., $C_O$, was 1 mol%, and the value of the effective segregation coefficient k was 0.04. In the device, a scintillator composed of the single crystal $Pr0.04\%:LiCaAlF_6$ was used. The effective atomic number was 15.

Pulse height spectra during thermal neutron irradiation and during thermal neutron shielding were obtained in the same manner as in Example 1, except that the pulse height spectra were measured using the resulting neutron detection device, with a voltage of 310 V being applied in reverse bias. Fig. 6 shows the resulting pulse height spectra.

Comparative Example 3

A neutron detection device was produced in the same manner as in Example 1, except that the respective materials were weighed in the following manner

|      |            |
| ---- | ---------- |
| LiF  | 437.3 g,   |
| $YF_3$ | 2545.5 g, and |
| $CeF_3$ | 17.2 g,  |

and that the resulting crystal was cut out of the portion with a Ce content $C_S$ of 0.5 mol% (the portion having a solidification rate g of 0.01 corresponding to the initial stage during single crystal growth) according to the aforementioned [Equation 2]. The amount of Ce in the materials, i.e., $C_O$, was 0.5 mol%, and the value of the effective segregation coefficient k was 1. In the device, a scintillator composed of the single crystal $Ce0.5\%:LiYF_4$ was used. The effective atomic number was 33.

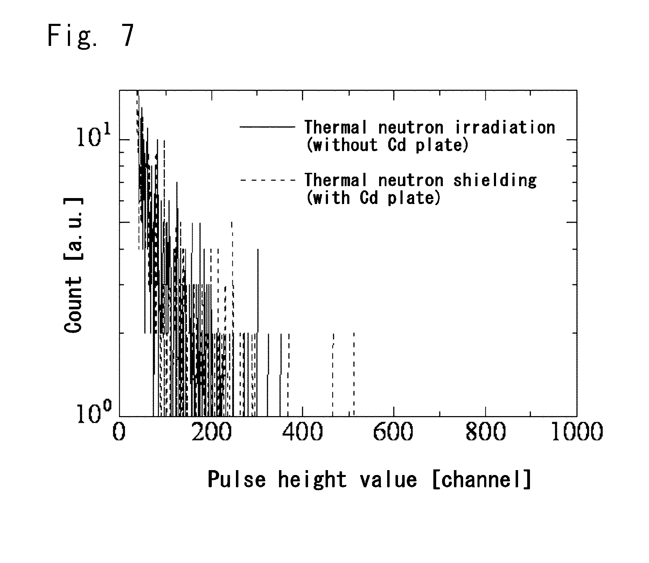

Pulse height spectra during thermal neutron irradiation and during thermal neutron shielding were obtained in the same manner as in Example 1, except that the pulse height spectra were measured using the resulting neutron detection device, with a voltage of 310 V being applied in reverse bias. Fig. 7 shows the resulting pulse height spectra.

In Example 1, the pulse height spectrum during thermal neutron irradiation and the pulse height spectrum during thermal neutron shielding were clearly different (see Fig. 4). Concretely, the frequencies of the electrical signals at the respective pulse height values (75 to 150 channels) during thermal neutron irradiation were higher than those during thermal neutron shielding. This proved that irradiation with thermal neutrons increased the frequencies of the electrical signals at the respective pulse height values (75 to 150 channels).

In Comparative Examples 1 to 3, on the other hand, no distinct differences were observed between the results during thermal neutron irradiation and during thermal neutron shielding, and the frequencies of the electrical signals were reduced in both cases (see Figs. 5 to 7). These findings indicate that even under irradiation with thermal neutrons, the neutron detection devices of Comparative Examples 1 to 3 cannot detect neutrons.

Based on the foregoing results of the pulse height spectrum measurements as well, the neutron detection device of the present invention was confirmed to be capable of detecting a thermal neutron. It was also confirmed that a colquiriite-type single crystal containing only Eu as a lanthanoid was suitable, but a crystal containing other rare earth element such as Ce or Pr was not suitable, as a scintillator for use in the neutron detection device. The reason may be that the scintillator containing Eu provides high emission intensity of a short wavelength, while the scintillator containing other element involves low emission intensity of a short wavelength.

Explanations of Letters or Numerals:

1    Crucible
2    Heater
3    Heat insulator
4    Movable stage

5 Seed crystal
6 Automatic diameter control device
7 Chamber
8 High frequency coil
9 neutron detection scintillator
10 Silicon photodiode
11 Light shield

**Claims**

1. A neutron detection device comprising a neutron detection scintillator composed of a colquiriite-type fluoride single crystal, and a silicon photodiode,
   wherein the single crystal contains only Eu as a lanthanoid and contains 0.80 atom/nm$^3$ or more of $^6$Li,
   a content of Eu is 0.0025 to 0.05 mol%, and
   a thickness of the scintillator exceeds 1 mm.

2. The neutron detection device according to claim 1, wherein the single crystal contains Eu in a basic single crystal of a composition represented by $LiCaAlF_6$, $LiSrAlF_6$ or $LiCa_{1-x}Sr_xAlF_6$ (0<x<1).

# Fig. 1

Grown crystal

1

3

8

7

6

5 — Material melt

2

Gas inlet

4

Vacuum evacuation device

# Fig. 2

9

11

10

Fig. 3

Fig. 4

Fig. 5

Fig. 6

Fig. 7

**INTERNATIONAL SEARCH REPORT**

| International application No. |
|---|
| PCT/JP2012/056009 |

A. CLASSIFICATION OF SUBJECT MATTER
*G01T3/06*(2006.01)i

According to International Patent Classification (IPC) or to both national classification and IPC

B. FIELDS SEARCHED

Minimum documentation searched (classification system followed by classification symbols)
G01T1/00-7/12, C09K11/00

Documentation searched other than minimum documentation to the extent that such documents are included in the fields searched
Jitsuyo Shinan Koho        1922-1996   Jitsuyo Shinan Toroku Koho   1996-2012
Kokai Jitsuyo Shinan Koho  1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2009/119378 A1  (Tokuyama Corp.), 01 October 2009 (01.10.2009), entire text; all drawings & US 2010/0314550 A1    & EP 2256177 A1 & CA 2717341 A          & CN 101945974 A & KR 10-2010-0125326 A | 1-2 |
| P,A | WO 2011/115179 A1  (Tokuyama Corp.), 22 September 2011 (22.09.2011), entire text; all drawings (Family: none) | 1-2 |

☐ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 April, 2012 (04.04.12) | 17 April, 2012 (17.04.12) |

| Name and mailing address of the ISA/ Japanese Patent Office | Authorized officer |
|---|---|
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012052526 W
- JP 2012052527 W
- WO 2009119378 A

**Non-patent literature cited in the description**

- **J. SCHELTEN.** *PhysicaB: Condensed Matter,* 1997, vol. 234-236, 1084-1086
- **K. NITTOH.** *Nuclear Instruments and Methods in Physics Research Section A Accelerators, Spectrometers, Detectors and Associated Equipment,* 2009, vol. 605 (1-2), 107-110